Europäisches Patentamt

**European Patent Office**

**Office européen des brevets**

(11) Numéro de publication: **0 031 024**
**A1**

# (12) DEMANDE DE BREVET EUROPEEN

(21) Numéro de dépôt: **80107020.2**

(22) Date de dépôt: **14.11.80**

(51) Int. Cl.³: **G 11 C 17/00**

(30) Priorité: **07.12.79 FR 7930422**

(43) Date de publication de la demande:
**01.07.81 Bulletin 81/26**

(84) Etats Contractants Désignés:
**DE FR GB IT NL SE**

(71) Demandeur: **International Business Machines Corporation**

**Armonk, N.Y. 10504(US)**

(72) Inventeur: **Grandguillot, Michel Joseph**
**16, rue des Chênes**
**F-91540 Mennecy(FR)**

(72) Inventeur: **Mollier, Pierre Bernard**
**15, rue de Ponthierry**
**F-77310 Boissise le Roi(FR)**

(72) Inventeur: **Nuez, Jean-Paul Jules Jean**
**34, rue des Coquelicots**
**F-91540 Mennecy(FR)**

(74) Mandataire: **Lattard, Nicole**
**COMPAGNIE IBM FRANCE Département de Propriété Industrielle**
**F-06610 La Gaude(FR)**

(54) **Mémoire permanente intégrée de grande densité.**

(57) --Mémoire à transistors comprenant n lignes de mots WLl à WLn et m lignes de bits BLl à BLm. -- La lecture des informations représentées par la présence ou l'absence d'un transistor ayant son émetteur connecté à une ligne de bits est réalisée au moyen de transistors de lecture TL. Les transistors TLl à TLm sont répartis en k groupes de m/k transistors disposés dans le même lit épitaxial de collecteur avec un contact collecteur commun Cl pour le premier groupe, Ck pour le $k^{ème}$ groupe, connecté à un circuit de lecture CLl, ..., CLk. Des circuits de sélection Gi permettent la sélection d'une des lignes BSi, avec $l \leq i \leq m/k$. -- Application aux mémoires permanentes de grande densité.

./...

Croydon Printing Company Ltd.

FIG. 1

# MEMOIRE PERMANENTE INTEGREE DE GRANDE DENSITE

## Description

### Domaine Technique

La présente invention concerne une mémoire permanente à transistors et plus particulièrement dans une telle mémoire, l'arrangement des transistors constituant les cellules avec les transistors de détection pour obtenir une densité d'emmagasinage très élevée.

### Etat de la Technique

Les mémoires permanentes à transistors sont bien connues et largement utilisées. Une telle mémoire comprend des lignes de mots et des lignes de bits orthogonales, aux intersections desquelles sont disposées les cellules d'emmagasinage. Une information binaire d'un type par exemple un "1" est emmagasinée dans une cellule lorsqu'elle comprend un transistor actif, c'est-à-dire lorsque le transistor a son collecteur relié à une tension de polarisation, sa base à la ligne de mot et son émetteur relié à la ligne de bit, tandis qu'une information binaire d'un autre type par exemple un "0" est emmagasinée dans une cellule lorsque cette cellule ne comporte pas de transistor ou lorsque dans cette cellule les connexions du transistor aux différentes lignes ne sont pas achevées.

La demande de brevet français publiée sous le numéro 2 261 594 concerne une mémoire morte programmable, à transistors bipolaires qui sont connectés ou non par un fusible dans le trajet collecteur, cette mémoire étant compatible avec les circuits logiques à émetteurs couplés (logique ECL). L'adressage d'une ligne de mots est réalisé au moyen d'un transistor d'adressage en ayant son émetteur couplé avec les émetteurs des transistors de la ligne de mots.

Les demandes de brevets français publiées sous les numéros 2 300 395 et 2 300 397 décrivent des moyens permettant d'inscrire les informations dans une mémoire de ce type programmable, dans laquelle les émetteurs des transistors des cellules sont ou non connectés aux lignes de bits par des résistances. La demande de brevet français publiée sous le numéro 2 300 396 décrit aussi une mémoire de ce type comportant des moyens pour que le temps d'accès aux informations dans la mémoire soit constant.

Dans ces trois dernières demandes la détection des informations est réalisée au moyen de transistors de lecture qui ont leurs émetteurs connectés aux lignes de bit et qui en conséquence constituent des commutateurs de courant avec les transistors des cellules de mémoire sélectionnées.

Les documents cités sont dirigés vers l'amélioration des performances d'ensemble de mémoires mortes et non vers l'amélioration de la densité et en conséquence de la capacité d'emmagasinage.

Objet de l'Invention

La présente invention a pour objet de réaliser une mémoire intégrée permanente de très grande densité, qui consomme peu de puissance et qui soit de faible coût.

La présente invention est mise en oeuvre dans une mémoire morte réalisée sur une microplaquette semiconductrice dans laquelle sont prévues m lignes de bits et n lignes de mots. Les cellules de mémoires sont constituées aux intersections des lignes de mots et de bits ce qui donne une capacité de nxm bits. A chaque intersection sont prévus des diffusions et contacts base et collecteur, le contact base étant connecté à une ligne de mots et le contact collecteur à une tension de fonctionnement. Le chargement de cette mémoire est réalisé par personnalisation de la matrice de cellules ainsi obtenue, en réalisant la diffusion et le contact émetteur dans les cellules où on désire écrire une information binaire d'un type par exemple un "1" et en ne les réalisant pas dans les cellules où l'on désire écrire une information binaire de l'autre type par exemple un "0". Les contacts émetteurs sont reliés aux lignes de bits. A chaque ligne de bit est connecté l'émetteur d'un transistor de détection, dont la base est reliée à une tension de référence et dont la tension collecteur est une indication de l'état de la cellule que l'on veut lire et qui a été sélectionnée par l'intermédiaire de la ligne de mot.

Conformément à la présente invention, les lignes de bits sont réparties en k groupes de m/k éléments, et en conséquence, les transistors de détection sont répartis en k groupes de m/k éléments. De façon à réduire au minimum l'écartement entre les lignes de bits et en conséquence à augmenter la densité, les m/k éléments de chaque groupe qui ont leurs collecteurs reliés en commun à un circuit de lecture sont situés dans le même lit de sous-collecteur ce qui permet de gagner de la surface sur le silicium et de diminuer la capacité collecteur.

De plus conformément à une autre caractéristique de l'invention, on utilise m/k circuits de commande de bits, chaque circuit de sélection étant connecté à k lignes de bits prises chacune dans un groupe différent. Ainsi seuls, k transistors de détection peuvent être rendus conducteurs parmi les m transistors, ce qui réduit la dissipation de puissance.

D'autres objets, caractéristiques et avantages de la présente invention ressortiront mieux de l'exposé qui suit, fait en référence aux dessins annexés à ce texte, qui représentent un mode de réalisation préféré de celle-ci.

4

## Brève Description des Figures

La figure 1 représente de façon schématique l'arrangement de la mémoire permanente conformément à l'invention.

La figure 2 représente une vue de dessus de deux cellules d'emmagasinage de la figure 1 intégrées dans une microplaquette.

La figure 3 représente une vue en coupe selon la ligne XX' de la figure 2.

La figure 4 représente une vue en coupe selon la ligne YY' de la figure 2.

La figure 5 représente une vue de dessus d'un groupe de transistors de lecture intégrés dans une microplaquette.

La figure 6 représente une vue en coupe selon la ligne ZZ' de la figure 5.

La figure 7 représente un schéma d'un circuit d'attaque BD de la figure 1.

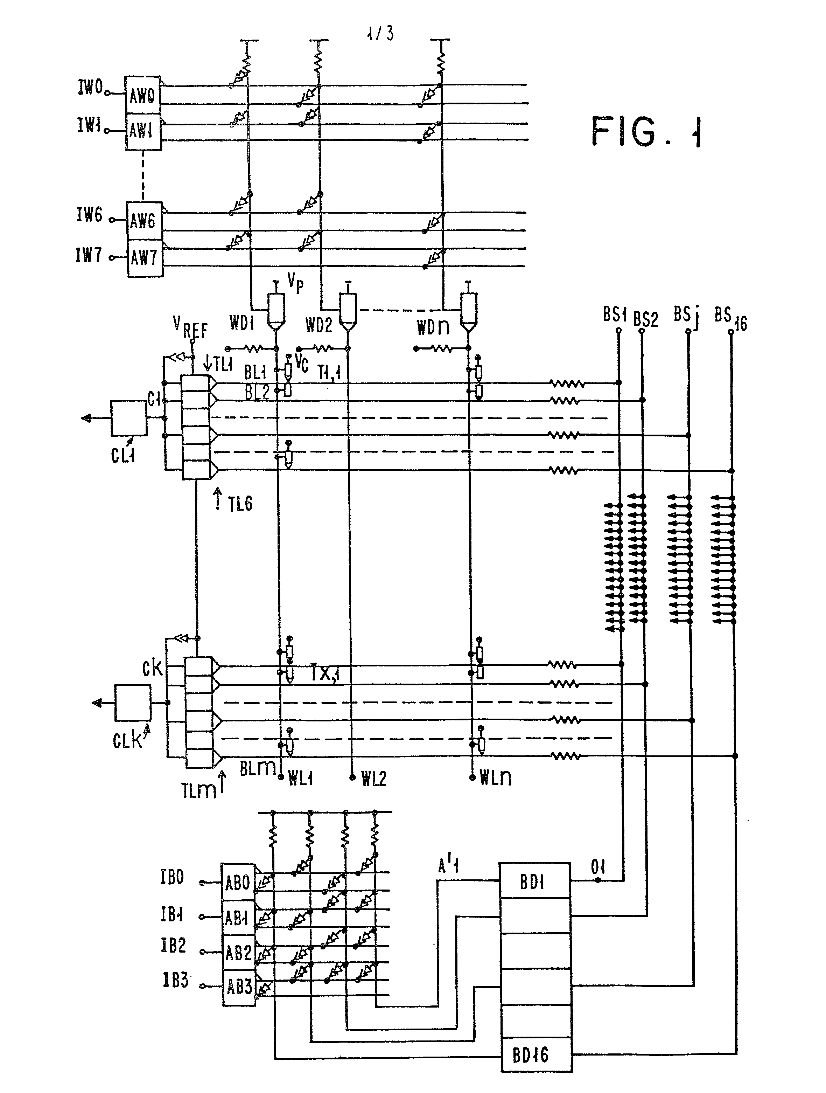

En référence à la figure 1, on va décrire la disposition de mémoire morte de capacité élevée, réalisée conformément à la présente invention. Grâce à cette disposition on peut intégrer sur une microplaquette de dimension standard une mémoire de capacité de nxm bits avec n = 256 et m = 288.

L'ensemble comprend des transistors $T_{i,j}$ disposés en matrice de m rangées et n colonnes, l'appellation $T_{i,j}$ représentant le transistor dans la $i^{ème}$ rangée et la $j^{ème}$ colonne. Les lignes verticales $WL_1$ à $WL_n$ sont les lignes de mots et les lignes $BL_1$ à $BL_m$ sont les lignes de bits. Seules les lignes extrêmes de l'ensemble sont représentées.

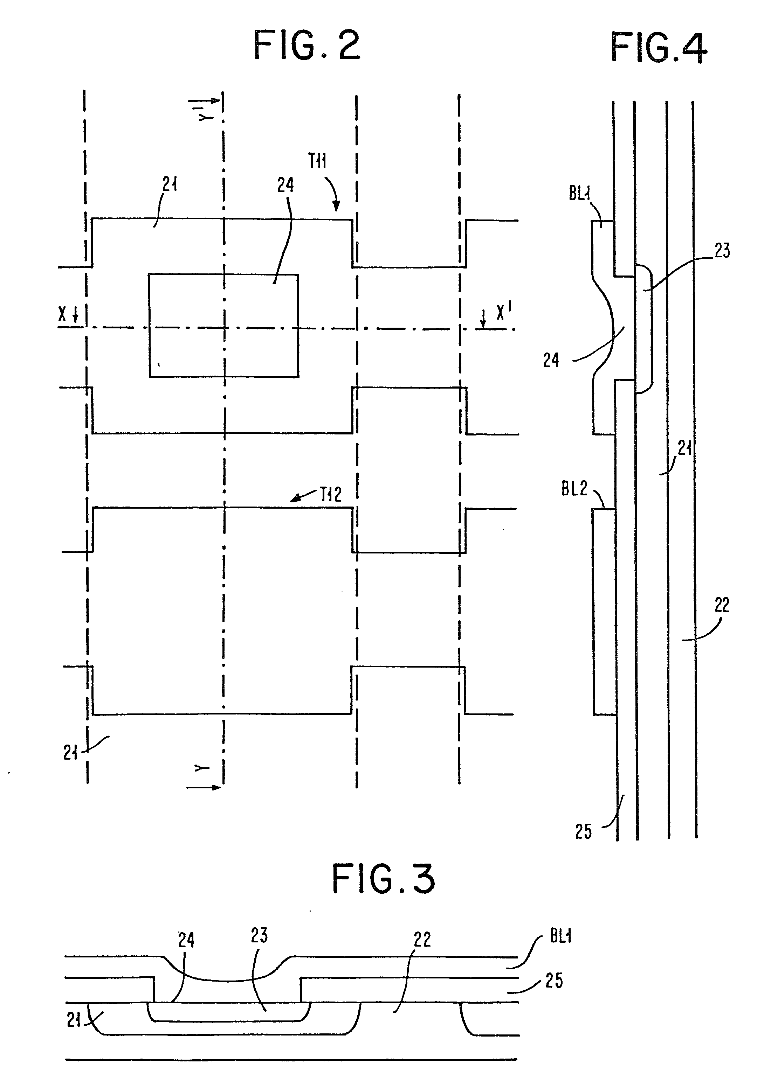

Chaque transistor $T_{i,j}$ a son collecteur connecté à une tension de polarisation Vc, sa base connectée à une ligne de mot WLj et l'émetteur est ou non réalisé et, si il existe, il est connecté à une ligne de bit BLi. Par exemple sur le dessin, le transistor T1,1 a son émetteur connecté à la ligne de bit BL1, il représente une information binaire d'un type, par exemple un "1" et le transistor T2,1 n'est pas achevé, c'est-à-dire que son émetteur n'a pas été constitué, il représente donc une information binaire de l'autre type, par exemple un "0". Pour remplir la mémoire avec les informations désirées, à chaque position de la matrice, on dispose un transistor avec ou sans émetteur. Pour cela dans une microplaquette dans laquelle sont prévues à chaque emplacement les diffusions collecteur et base avec les contacts appairés, on termine ou non le transistor par une diffusion et contact émetteur. L'intégration de deux cellules, l'une avec émetteur et l'autre sans émetteur est représentée sur la figure 2.

A chaque ligne de mot WLj est associé un transistor d'attaque WDj commandé par la sortie (indice j) d'un décodeur à $n=2^X$ sorties et x entrées. Dans le cas d'une mémoire à 256 lignes de mots n=256, x=8 et le décodeur comprend huit entrées IW0 à IW7 recevant l'adresse de la ligne à sélectionner. Le décodeur est du type classique à diodes Schottky commandé par huit circuits générateurs AW0 à AW7, valeur vraie/valeur complémentaire. Chaque circuit générateur a deux sorties, la sortie valeur complémentaire étant repérée par le signe ∟ . Les seize lignes de sortie constituent les lignes horizontales d'une matrice de diode de Schottky à n lignes horizontales qui attaquent les bases des transistors WD1 à WDn. Le réseau fournit un niveau haut sur la base du transistor WD correspondant à la ligne de mot sélectionnée et un niveau bas sur les autres lignes. Ce type de circuit de décodage ne faisant pas partie de l'invention ne sera pas décrit plus en détail et il est bien entendu que d'autres types de décodeurs d'adresses peuvent être utilisés.

Les transistors WD1 à WDn ont leurs émetteurs connectés aux lignes de mots WLi à WLn et leurs collecteurs connectés à une tension de polarisation Vp.

Les lignes de bits, BL1 à BLm sont connectées à une de leurs extrémités aux émetteurs de transistors de lecture TL1 à TLm. Ces transistors n'ont pas été tous représentés sur la figure dans un but de clarté.

Les autres extrémités sont reliées par des résistances à 16 lignes de sélection de bits BS1 à BS16 d'une façon qui sera décrite par la suite.

Les seize lignes de sélection de bit BS1 à BS16 sont adressées par seize circuits de sélection de ligne de bit, BD1 à BD16 commandés par les seize sorties d'un circuit décodeur d'adresse qui est du même type que le circuit de décodage précédemment décrit, mais ne comporte que quatre entrées, IB0 à IB3 et quatre circuits générateurs valeur vraie/valeur complémentaire AB0 à AB3, dont les huit sorties constituent les lignes horizontales d'une matrice de diodes de Schottky dont les seize lignes horizontales, attaquent les décodeurs BD1 à BD16. Tout autre type de décodeur satisfaisant les niveaux d'entrée requis par les générateurs BD1 à BD16 peut être utilisé. Une seule des lignes BSj doit être sélectionnée au niveau bas, les autres lignes étant au niveau haut.

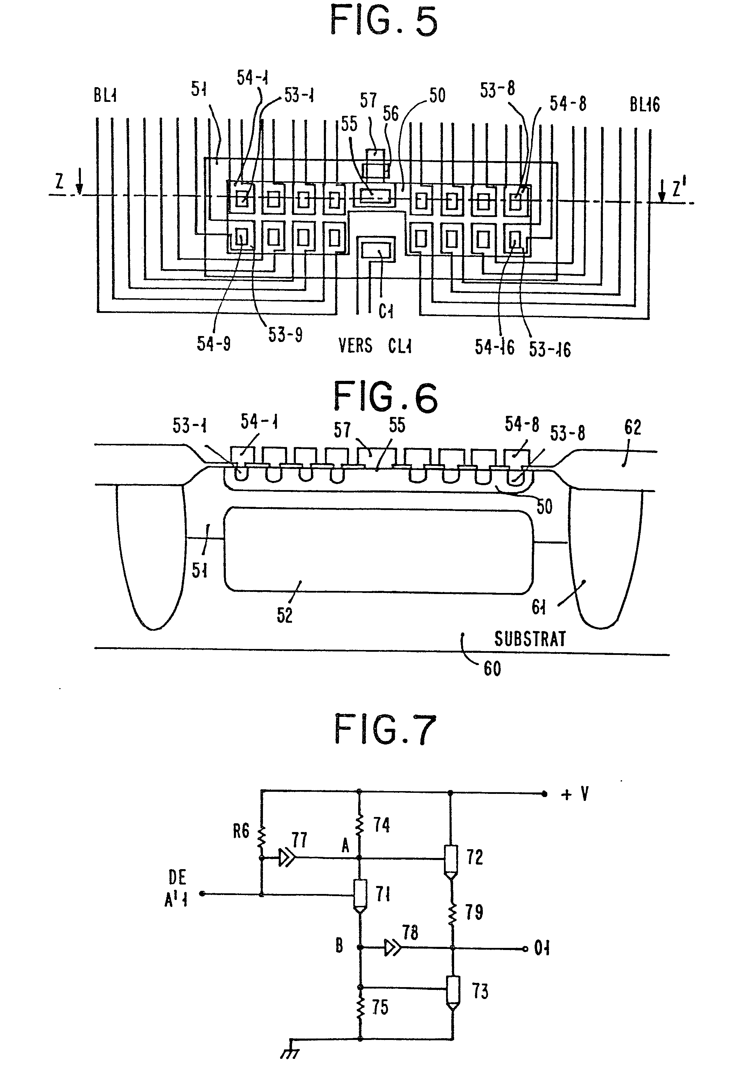

Conformément à la présente invention, les transistors de lecture TL sont groupés en k groupes de m/k éléments. Dans l'exemple choisi, k est égal à 18. Les transistors de chaque groupe sont disposés dans le même lit épitaxial de collecteur. Comme on pourra le voir sur la figure 5, la région base est commune à tous les transistors du groupe, de même que la région collecteur. Il n'y a donc qu'un seul contact collecteur C, qui est connecté à un circuit de lecture CL. Le point C1 du groupe 1 étant connecté au circuit CL1 et le point Ck du groupe k étant connecté au circuit CLk.

Les premiers transistors de chaque groupe TL1, TL(1+m/k),

TL(1+2m/k), ..., TL[1+(k-1)/m/k] ont leurs émetteurs connectés à la ligne BS1, les deuxièmes transistors TL2, TL(2+m/k), etc. ont leurs émetteurs connectés à la ligne BS2 et les m/k$^{ième}$ transistors TL16, TL(16+m/k) dans l'exemple choisi ont leurs émetteurs connectés à la ligne BS16. Ceci est représenté schématiquement sur la figure 1 par les flèches partant des lignes BS1 à BS16.

La lecture est réalisée de la façon suivante. La ligne de mots comportant les bits d'information à lire est d'abord sélectionnée par le circuit S correspondant, supposons que ce soit la ligne 1 sélectionnée par le circuit WD1. Simultanément grâce à un des circuits BD1 à BD16, une des lignes BS1 à BS16 est sélectionnée pour lire l'information désirée dans la ligne 1, supposons BS2.

BS2 étant sélectionnée, les transistors T2,1, T[(2+m/k),1], T[2+(k-1)m/k,1] ayant des émetteurs sont montés en commutateurs de courant avec les deuxièmes transistors de lecture dans chacun des groupes, c'est-à-dire TL2, TL(2+m/k), TL[2+(k-1)m/k], leurs émetteurs étant reliés à un niveau bas par la ligne BS2. En conséquence pour les commutateurs dans lesquels un transistor d'emmagasinage est complet par exemple Tx,1 soit T[2+(k-1)m/k,1], le transistor de lecture est bloqué, ce qui est détecté par le circuit CLk. Pour les commutateurs dans lesquels un transistor d'emmagasinage n'est pas complet par exemple T2,1, le transistor de lecture (TL2) est conducteur, ce qui est détecté par le circuit CL1.

Les circuits CL1 à CLk indiqueront donc l'état de tous les deuxièmes transistors de chaque groupe, du mot sélectionné.

Les figures 2, 3 et 4 représentent une vue de dessus et deux vues en coupe de deux cellules de mémoire. Comme on peut le voir sur la figure 2, les transistors T1,1 et T1,2 sont disposés dans une même diffusion base 21 délimitée par les traits en pointillés dans une couche épitaxiale de collecteur 22. Lorsque le transistor est complet, ce qui est le cas pour T11, une région émetteur 23 est diffusée dans la région de base 21 avec un contact métal à cette région émetteur, 24 comme on peut le voir sur les coupes. Lorsque le transistor n'est pas complet, ce qui est le cas pour T21, la région émetteur n'est pas présente. Les lignes BL1 et BL2 sont situées au-dessus de l'ensemble semi-conducteur séparé par une couche d'oxyde 25, au travers de laquelle sont prévus les contacts émetteurs lorsque cela est nécessaire. Les lignes horizontales BL1 et BL2 sont réalisées au premier niveau de métal étant donné qu'elles peuvent se connecter directement au silicium à chaque cellule. Les lignes verticales non représentées ne se connectent au silicium que toutes les huit cellules par exemple elles se trouvent donc au deuxième niveau de métal et une fois toutes les huit cellules ont réalise un contact à la base par l'intermédiaire d'un trou de connexion deuxième à premier niveau de métal.

Cette disposition qui ne fait pas partie de la présente invention ne sera pas décrite plus en détail.

On va maintenant décrire en référence aux figures 5 et 6 la disposition des transistors de lecture TL dans chaque groupe, par exemple dans le premier groupe 1. Les seize transistors sont disposés dans une zone de diffusion base commune 50 diffusée dans une zone épitaxiale de collecteur 51 associée à une région de sous-collecteur 52. Deux rangées de huit diffusions émetteur 53-1 à 53-8 et 53-9 à 53-16 sont reliées aux lignes BL1 à BL16 par les contacts associés 54-1 à 54-8 et 54-9 à 54-16. L'ensemble comprend un contact collecteur commun aux seize transistors qui correspond au point C1 de la figure 1 avec une ligne allant au circuit de lecture CL1, le contact à la base 55 avec une zone de métallisation 56, et un trou de connexion premier niveau de métallisation à second niveau 57 qui est utilisé pour amener la tension de référence par une métallisation au second niveau.

Dans un mode de réalisation de l'invention dans lequel les transistors intégrés dans la matrice sont des transistors NPN, les transistors de lecture sont aussi des transistors NPN, en conséquence, ils sont intégrés dans un substrat 60 de type P. Le groupe des seize transistors est isolé par un mur d'isolation 61 de type P+, la région de sous-collecteur 52 est de type N+. La région collecteur 51 est de type N, la région base 50 de type P et les régions émetteurs 53 de type N+. Une couche d'oxyde 62 à travers laquelle sont réalisés les contacts, est prévue sur la surface de l'ensemble.

La disposition réalisée conformément à l'invention permet d'obtenir une bonne compensation en température et un bon suivi des variations de courant entre les transistors dans les cellules et les transistors de lecture puisqu'ils présentent la même topologie. Du fait que seulement une partie des sources de courant est mise en service grâce à la sélection d'une des lignes BS1 à BS16, on réalise une économie importante en dissipation de puissance. Enfin, l'intégration de seize transistors de lecture par groupe, permet d'économiser de la surface et de diminuer la capacité collecteur des transistors de lecture. Le pas de la mémoire est aussi fixé uniquement par les transistors des cellules. Ce pas dans le cas où on choisit k=18 peut être amené à 8,2 microns dans la réalisation décrite à titre d'exemple.

Sur la figure 7, est représenté un des circuits BD1 à BD16, utilisé pour la sélection d'une ligne BS1 à BS16, par exemple le circuit BD1 qui reçoit le signal de sélection du circuit de décodage A'1 (voir figure 1).

Ce circuit comprend trois transistors 71, 72, 73. La base du transistor 71 est reliée à la sortie A'1, son collecteur est relié à une tension +V par une résistance 74 et son émetteur est relié à la masse par une résistance 75. Une résistance 76 est montée entre la tension +V et la base du transistor 71 et une diode de Schottky 77 a son anode connectée à la base du transistor 71 et sa cathode reliée au collecteur du transistor 71 au point A.

Le point A est connecté à la base du transistor 72 dont le collecteur est connecté à la tension +V et l'émetteur est connecté par une résistance 79 au collecteur du transistor 73. Le point B à l'émetteur du transistor 71 est connecté à l'anode d'une diode de Schottky 78 dont la cathode est connectée au collecteur du transistor 73. L'émetteur du transistor 73 est connecté à la masse. Le point 01 est pris au collecteur du transistor 73.

Le fonctionnement du circuit est le suivant. Le premier étage 71 constitue un étage déphaseur, il met les signaux en A et B en opposition de phase de façon à pouvoir attaquer le push-pull de sortie.

Un niveau haut venant de A'1, rend le transistor 71 conducteur. Le potentiel au point B monte de 1VBE qui est le potentiel base-émetteur d'un transistor. Comme le transistor 71 est conducteur, sa diode d'antisaturation 77 est conductrice et le potentiel au point A est égal au potentiel d'entrée moins la tension de la diode VF soit 1 volt.

Donc le transistor 73 est conducteur. Il passe dans le transistor 72 un courant de quelques centaines de microampères limité par la résistance 79. Le transistor 73 est un transistor de grande taille, il est capable de tirer transitoirement vers la masse un courant élevé, son courant base étant de l'ordre du milliampère.

Un niveau bas venant de A'1 bloque les transistors 71 et 73, le transistor 73 décharge sa base dans 75, la tension au point A monte vers +V. L'émetteur du transistor 72 suit le potentiel du point A. La ligne n'est pas sélectionnée.

Bien que l'on ait décrit dans ce qui précède et représenté sur les dessins les caractéristiques essentielles de l'invention appliquées à un mode de réalisation préféré de

11

celle-ci, il est évident que l'homme de l'art peut y apporter toutes modifications de forme ou de détail qu'il juge utiles, sans pour autant sortir du cadre de ladite invention.

12

REVENDICATIONS

1. Mémoire permanente intégrée comprenant nxm cellules d'emmagasinage situées aux intersections de m lignes de bits et n lignes de mots dans lesquelles une information binaire d'un type est représentée par la présence d'un transistor dans la cellule, ledit transistor ayant sa ·base connectée à une ligne de mot et son émetteur connecté à une ligne de bit et une information binaire d'un autre type est représentée par l'absence de transistor dans la cellule, ladite mémoire étant du type dans laquelle la lecture est réalisée au moyen de m transistors de lecture, ayant leurs émetteurs connectés aux lignes de bits et leurs bases connectées à une tension de référence, caractérisée en ce que:

les transistors de lecture (TL) sont répartis en k groupes adjacents de m/k éléments consécutifs, k étant un entier sous-multiple de m, les transistors dans chaque groupe étant disposés dans le même lit épitaxial de collecteur (51) avec un contact collecteur (C1) commun à tous les transistors, le contact collecteur de chaque groupe étant connecté à un circuit de lecture (CL).

2. Mémoire intégrée selon la revendication 1, caractérisée en ce que dans chaque groupe la région de base (50) est commune à tous les transistors avec un seul contact de base (57, 55) pour réaliser la connexion à la tension de référence.

3. Mémoire intégrée selon la revendication 1 ou 2 caractérisée en ce qu'elle comprend m/k lignes de sélection de bits BSi avec $1 \leq i \leq m/k$, à chacune desquelles sont connectées k lignes de bits de façon qu'à chaque ligne BSi soient connectés les émetteurs des $i^{\text{ième}}$ transistors de lecture de chaque groupe.

4. Mémoire intégrée selon la revendication 1, 2 ou 3 caractérisée en ce qu'elle comporte n circuits de sélection de lignes de mots, chaque circuit de sélection permettant de sélectionner une ligne de mot désirée pour la lecture des informations dans cette ligne.

5. Mémoire intégrée selon l'une quelconque des revendications précédentes caractérisée en ce qu'elle comporte m/k circuits de sélection de lignes de bits avec $1 \leq i \leq m/k$ permettant la sélection d'une des lignes (BS) ayant une adresse choisie, chacun des circuits ayant des entrées recevant l'information d'adresse choisie, et une sortie connectée à une ligne de sélection de lignes de bits, pour réaliser la sélection de la ligne ayant l'adresse choisie.

6. Mémoire intégrée selon l'une quelconque des revendications précédentes caractérisée en ce que les transistors des cellules et de lecture sont des transistors NPN.

FIG. 1

0031024

# FIG.2

# FIG.4

# FIG.3

# FIG. 5

BL1     51  54-1  53-1   57  56  50   53-8  54-8   BL16

55

Z

Z'

54-9  53-9    C1

VERS CL1    54-16  53-16

# FIG.6

53-1  54-1   57  55   54-8  53-8   62

50

51

52    61

SUBSTRAT

60

# FIG.7

+ V

R6   77  A  74   72

DE
A'1     71   79

B   78   01

73

75

Office européen
des brevets

**RAPPORT DE RECHERCHE EUROPEENNE**

Numéro de la ,ande
EP 80 10 7020

| | DOCUMENTS CONSIDERES COMME PERTINENTS | | CLASSEMENT DE LA DEMANDE (Int. Cl.³) |
|---|---|---|---|
| Catégorie | Citation du document avec indication, en cas de besoin, des parties pertinentes | Revendication concernée | |
| | IEEE JOURNAL OF SOLID-STATE CIR-CUITS, vol. SC-5, no. 5, octobre 1970 New York US J.C. BARRETT et al.: "Design considerations for a high-speed bipolar read-only memory", pages 196-202 <br><br> * Page 199, colonne de droite, ligne 39 - page 202, colonne de gauche, ligne 17, figures 9,11 * <br><br> -- | 1-6 | G 11 C 17/00 |
| | | | **DOMAINES TECHNIQUES RECHERCHES (Int. Cl.³)** |
| | IBM TECHNICAL DISCLOSURE BULLETIN vol. 14, no. 11, avril 1972, New York US T.H. BAKER et al.: "Decode Transistor", page 3245 <br><br> * En entier * <br><br> ---- | 1,2 | G 11 C 17/00 |
| | | | **CATEGORIE DES DOCUMENTS CITES** <br><br> X: particulièrement pertinent <br> A: arrière-plan technologique <br> O: divulgation non-écrite <br> P: document intercalaire <br> T: théorie ou principe à la base de l'invention <br> E: demande faisant interférence <br> D: document cité dans la demande <br> L: document cité pour d'autres raisons <br><br> &: membre de la même famille, document correspondant |

Le présent rapport de recherche a été établi pour toutes les revendications

| Lieu de la recherche | Date d'achèvement de la recherche | Examinateur |
|---|---|---|
| La Haye | 26-03-1981 | DEGRAEVE |